# EUROPEAN PATENT SPECIFICATION

(11) **EP 0 368 528 B1**
(45) Date of publication and mention of the grant of the patent: **14.09.1994**
(21) Application number: 89311188.0
(22) Date of filing: 30.10.1989
(51) Int. Cl.: H03G 3/34, H03F 1/30

(54) **Audio amplifier with mute and stand-by states**
Audioverstärker mit Stumm- und Bereitschaftzustand
Amplificateur audio avec états d'attente et muets

(30) Priority: 09.11.1988 IT 2255688
(43) Date of publication of application: 16.05.1990
(73) Proprietor: SGS-THOMSON MICROELECTRONICS s.r.l., 20041 Agrate Brianza (Milano) (IT)
(72) Inventor: Torazzina, Aldo, I-20052 Monza, (MI) (IT)
(74) Representative: Robinson, John Stuart

(56) References cited:
- EP-A- 0 159 079
- EP-A- 0 249 729
- DE-A- 1 951 457
- DE-A- 3 337 072
- GB-A- 2 056 208

## Description

The present invention relates to an audio amplifier with a "mute" state for muting an audio signal and a "stand-by" state with a low consumption of electrical energy.

With the introduction of modern audio apparatus with high-level performance for "high-fidelity" applications, for example for televisions and for car radios, constructed essentially using integrated circuits, mute and stand-by states have become a normal requirement. At the same time, ever greater care has been taken to prevent annoying noise which can be heard by the human ear ("crackles") due to the switching transients of electronic components, not only during the stages of switching on and switching off, but also during the transitions from a state of normal operation to a mute state or a stand-by state with low consumption.

As is known, an operative mute state, usually defined in the technical literature by the term "mute", is generally set from outside using an appropriate control when a user wishes to stop the output of sounds from the loudspeaker connected to the amplifier for only a short period. In order to obtain a "mute" state it is sufficient to prevent the transfer of audio signals to the loudspeaker while continuing normally to supply the audio amplifier. The "mute" state can also be automatically set, by appropriate circuits in the audio apparatus, for predetermined time periods during the switch-on or switch-off transients of the audio apparatus so as to prevent the transfer of noise generated upstream of the audio amplifier connected to the loudspeaker as output to the loudspeaker.

Even if the "mute" state is set by circuit means contained within the audio amplifier, it cannot, however, be used to eliminate noise generated in the audio amplifier itself which is essentially due to the instability of a power output stage during switching transients.

A low consumption stand-by state, usually defined in the technical literature by the term "stand-by", is that state in which the greatest possible number of components of an audio apparatus and in particular its audio amplifier are brought into a disabled or cut-off condition, while the connections with a supply voltage source are maintained. Only those components absolutely necessary for resetting the normal functions of the other components when the "stand-by" state is discontinued remain in operation. A "stand-by" state is generally set externally by the user by means of an appropriate control, but may also be set automatically to provide forms of protection, for instance in cases of overloading, until abnormal operating conditions are removed.

At present, arrangements for the production of a "stand-by" state are separate from those for the production of a "mute" state and separate circuits are used.

As regards the problem of noise caused by switching transients, the technical solutions used in modern integrated circuit audio apparatus are separate depending on whether the noise is generated upstream of the audio amplifier or in the audio amplifier itself and in particular in its power output stage. In the first case, as has been noted, a "mute" state having a limited duration in time can be effectively used only during the time periods of the switching transients in which the noise may be generated. In the second case, use is made of circuit devices of the type disclosed, for instance, in the British Patent Application GB-A-2 056 208, which are designed to suppress the switching transients of the components operating along the signal path.

EP-A-0159079 discloses an audio amplified having "mute" and "stand-by" states. The amplifier passes through the "mute" and "stand-by" states passing between a state of normal operation and a cut-off state.

According to a first aspect of the invention, there is provided an audio amplifier as defined in the appended Claim 1.

Preferred embodiments of the invention are defined in the other appended Claims.

It is thus possible to provide an audio amplifier which can be monolithically integrated, in which "mute" and "stand-by" functions and the elimination of the audio noise caused by switching transients are provided in a common circuit arrangement in a more economic and effective way than in the known devices.

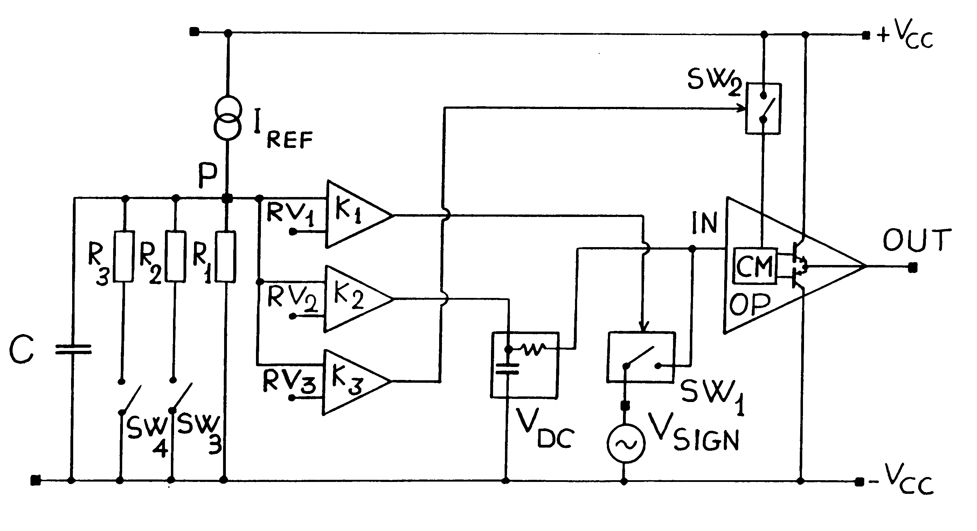

The invention will be further described, by way of example, with reference to the accompanying drawing, which is a circuit diagram, partly in block form, of an audio amplifier constituting a preferred embodiment of the invention.

An audio amplifier comprises an amplifier circuit OP, shown by a triangular block connected between a first terminal +Vcc and a second terminal -Vcc of a supply voltage source. A power output stage, formed by two transistors in "push-pull" configuration and having an output terminal which is the output terminal OUT of the amplifier circuit OP, is shown diagrammatically within the block. A load (not shown), for instance a loudspeaker, is connected to the output terminal via a capacitative component. Biasing circuit means of the power output stage and of the other components of the amplifier circuit are also shown in the block OP by a block CM.

The amplifier circuit OP may simply be an operational power amplifier having an inverting input to which internal feedback networks of the amplifier are connected, these networks determining the direct current and alternating current gains, and a non-inverting input to which an audio signal to be amplified is supplied together with a direct voltage for the biasing of the output.

The block OP has an input terminal IN corresponding to a non-inverting operational amplifier input terminal which is connected via a first switch SW1 to an audio signal source VSIGN and which is also connected to a biasing voltage generator VDC. In an alternative embodiment, there could also be a second input terminal for this latter connection. The amplifier circuit OP is designed to transfer as output with predetermined gains both the signal and the biasing voltage.

The biasing voltage generator VDC is of the type in which the voltage generated depends on the charge state of a capacitor such that, when the generator is activated, the value of the bias voltage increases gradually from zero to a predetermined constant value over a predetermined time interval, while the reverse takes place when the generator is deactivated.

The biasing circuit means are connected to the first terminal +Vcc of the supply voltage source via a second switch SW2.

The audio amplifier further comprises first K1, second K2, and third K3 threshold comparators, each having first and second input terminals and an output terminal. The first input terminal of each of the threshold comparators is connected to a common circuit node P which forms a control terminal for the audio amplifier. A capacitor C is connected between the circuit node P and the second terminal -Vcc of the supply voltage source.

The second input terminal of the comparator K1, the second input terminal of the comparator K2 and the second input terminal of the comparator K3 are connected to first RV1, second RV2, and third RV3 voltage references, respectively.

The output terminals of the first, second, and third threshold comparators are connected to the first switch SW1, to the biasing voltage generator VDC, and to the second switch SW2, respectively. The switches SW1 and SW2 are open when the threshold comparators K1 and K3 connected thereto are not generating any output signal and are closed when the comparators are generating output signals. The biasing voltage generator VDC is activated by the signals generated by the threshold comparator K2 connected thereto and deactivated by their discontinuation.

The switch SW1 can be used to enable or disable the supply not only to the biasing circuit means CM but also to other circuit components of the audio amplifier which are also disabled when the threshold comparator K3 is not generating any output signal. In an alternative embodiment, these circuit components could be supplied via different switches controlled by the same threshold comparator K3.

The problem of the noise arising from switching transients generated either upstream of the amplifier in other components of the audio apparatus or in the amplifier itself in its power output stage is solved in a simple but effective way in the audio amplifier, which also provides the "mute" and "stand-by" functions in a very economic way. A main characteristic feature of the audio amplifier is that the "mute" and "stand-by" states are included among the obligatory physical states of transition between a state of normal operation in which all the components of the amplifier are active and a cut-off state in which all the components are cut off. A single control terminal, the circuit node P, allows the audio amplifier to be placed in a "mute" or "stand-by" state and simultaneously to act as an automatic control terminal in order to eliminate the adverse effects ("crackles") of the noise due to the switching transients.

The voltage references RV1, RV2 and RV3 are selected such that, above a first predetermined potential value U1 at the common circuit node P, there is normal operation of the audio amplifier in which all the components are active and therefore the comparators each generate an output signal, as a result of which an audio signal from the signal source VSIGN is normally amplified and transferred as output.

The voltage references are also selected so that, for potential values at the node P which are lower than or equal to the value U1 and greater than a second predetermined potential value U2 which is lower than U1, the first threshold comparator K1 is automatically disabled or cut off. For potential values at the circuit node P which are lower than or equal to the value U2 and greater than a third predetermined potential value U3 which is lower than U2, the second threshold comparator K2 is also automatically disabled or cut off. For potential values at the circuit node P which are lower than or equal to the value U3, the third threshold comparator K3 is also automatically disabled or cut off. The potential value U3 is selected such that it is always greater than the "earth" potential value which the node P assumes when the audio amplifier is completely cut off, or when the supply is interrupted and all the capacitances of the circuit have been discharged.

The capacitor C connected between the node P and the second terminal -Vcc of the supply voltage source, or "earth terminal", ensures that all the potential variations at the node P take place gradually and continuously. Even when a potential value at the node P is set externally to bring about a "mute" or "stand-by" state, the actual potential changes gradually and continuously to the set value which is reached in a time interval which is a function of the capacitance of the capacitor C.

It is precisely this gradual nature of the potential variations at the circuit node P which makes it possible to solve the problem of the noise caused by the switching transients effectively and with particularly simple circuit arrangements. By way of example, passage from a state of normal operation to the "mute" state will be examined.

By setting a predetermined potential value lower than or equal to the value U1 but greater than the value U2 at the node P, the actual potential value at the node P varies continuously until it is the desired value only after a time interval determined by the capacitance of the capacitor C causing, as soon as this actual value becomes equal to U1, the deactivation of the comparator K1 and the resultant opening of the switch SW1. The transfer of the audio signal via the amplifier circuit OP is thus prevented and the "mute" function provided. It is important to note that an identical initial transition to the "mute" state also takes place during a cut off transient since, during such a transient, the potential at the node P tends in a non-abrupt way towards the same value as the earth potential and therefore necessarily also assumes the value U1 prior to cut off.

Since an audio apparatus normally comprises an appropriate capacitor (not shown) for the general reduction of the effects of an abrupt discontinuation of the supply on cut off, it is possible, by dimensioning the capacitance of the capacitor C appropriately with respect to the capacitance of the above mentioned capacitor, to enable the "mute" state to be reached before the components upstream of the audio amplifier begin to generate noise due to the switching transients. When this noise occurs it can no longer be amplified and transduced into annoying acoustic noise ("crackles"). Similarly, during a switch-on transient this noise is avoided by leaving the "mute" state only when the transients caused upstream of the audio amplifier have died away.

Passage from the state of normal operation to the "stand-by" state will now be considered.

By setting a predetermined potential value lower than or equal to the value U3, but greater than the "earth" potential value, at the node P, the actual potential value at the node P varies continuously until it becomes the desired value only after a time interval determined by the capacitance of the capacitor C. In the first instance, the comparator K1 is disabled as soon as this actual potential value at the node P becomes equal to U1 and the switch SW1 is consequently opened, with the "mute" state. The comparator K2 is then disabled when the potential value at the node P drops to the value U2 as a result of which a progressive and gradual decrease to zero begins in the biasing voltage generated by the generator VDC.

Finally, when the potential value at the node P is equal to U3 the comparator K3 is also disabled, the switch SW2 is opened and consequently at least the biasing circuit means CM contained in the amplifier circuit OP are disabled, thereby bringing about the "stand-by" state since the general supply has not been discontinued as happens when switching off. The "mute" state also continues.

It is now possible to examine how the problem of the noise caused by instability during the switching of the power output stage of the amplifier circuit OP is solved in a particularly simple way.

As mentioned above, during a switch off transient, for instance, the potential at the node P varies continuously until it reaches the same value as the earth potential. When the potential has the value U1, the audio amplifier is placed in the "mute" state and is then, at the value U3, placed in the "stand-by" state, which does not exclude the "mute" state, until the "general" capacitor, discussed above, connected directly to the supply is also completely discharged.

However, before the audio amplifier is placed in the "stand-by" state, the comparator K2 is disabled when the potential value at the node P is equal to U2. When the comparator K2 is no longer generating output signals, the deactivation of the biasing voltage generator VDC does not take place abruptly. Instead, the supply of the biasing voltage is gradually reduced to zero over a predetermined period such that the power output stage of the amplifier circuit OP is brought, with no instability in normal operation, to a minimum conductive level or to cut off before the threshold comparator K3 is disabled. The amplifier is then switched to "stand-by" with the discontinuation of the supply to the biasing circuit means CM within the amplifier circuit OP.

Thus, noise caused by instability of the power output stage due to switching transients is automatically avoided both in the case in which a "stand-by" state is set and in the case of complete switch off of the amplifier. Obviously any noise caused by instability of the output stage due to switch-on or to passage from a "stand-by" state to normal operation is similarly avoided as a result of the gradual increase in the conduction of the output stage after re-activation of the comparator K2 which can only take place after re-activation of the comparator K3 which restores the supply to the biasing circuit means C.

In the embodiment shown in the drawing, the audio amplifier further comprises first R1, second R2, and third R3 resistors connected in parallel with the capacitor C between the circuit node P and the second terminal -Vcc of the supply voltage source. A constant current generator IREF is connected between the first terminal +Vcc of the supply voltage source and the circuit node P. The resistors R2 and R3 are connected to the terminal -Vcc via third SW3 and fourth SW4 switches respectively.

During normal operation of the audio amplifier, the switches SW3 and SW4 are open and the voltage drop across the resistor R1 maintains the potential at the circuit node P at a value enabling the three threshold comparators to be active and to generate output signals.

The values of the three resistors R1, R2 and R3 are such that, when the switch SW3 is closed and the resistor R2 is thus connected in parallel with the resistor R1, the potential at the node P drops to a value bringing about, through the deactivation of the comparator K1 alone, a "mute" state; when the switch SW4 is closed or both the switches SW3 and SW4 are closed and the resistor R3 or the parallel combination of the resistors R2 and R3 is connected in parallel with the resistor R1, the potential at the node P drops to a value bringing about, through the deactivation of the comparators K2 and K3 as well, a "stand-by" state.

## Claims

1. An audio amplifier comprising an amplifier circuit (OP), which has at least one input terminal (IN) for connection to a biasing voltage generator (VDC) of the type in which the voltage generated depends on the charge condition of a capacitor, at least one output terminal (OUT) for connection to a load, an output stage connected between first (+Vcc) and second (-Vcc) supply terminals, biasing circuit means (CM) for biasing at least the output stage connected between the first (+Vcc) and second (-Vcc) supply terminals, and a common circuit node (P) which is connected to the second supply terminal (-Vcc) via a capacitor (C) and to the first supply terminal (+Vcc) via a current generator source (IREF) the amplifier being characterized by comprising a first switch (SW1) for connecting said input terminal to a signal source (VSIGN) and by comprising first (K1), second (K2), and third (K3) threshold comparators, each having first and second input terminals and an output terminal, the first input terminal of each of the threshold comparators being connected to said common circuit node (P), the second input terminal of the first threshold comparator (K1), the second input terminal of the second threshold comparator (K2) and the second input terminal of the third threshold comparator (K3) being connected to first (RV1), second (RV2) and third (RV3) voltage references, respectively, the output terminal of the first threshold comparator (K1), the output terminal of the second threshold comparator (K2), and the output terminal of the third threshold comparator (K3) being connected to the first switch (SW1), to the biasing voltage generator (VDC), and to a second switch (SW2), respectively, the second switch being connected in series with the biasing circuit means (CM) between the first (+Vcc) and second (-Vcc) supply terminals, the first (SW1) and second (SW2) switches and the biasing voltage generator (VDC) being controlled by the first (K1), third (K3), and second (K2) threshold comparators, respectively.

2. An audio amplifier as claimed in claim 1, characterized in that the first voltage reference (RV1) is arranged to provide a reference voltage such that the first threshold comparator (K1) generates a control signal for the closure of the first switch (SW1) only for potential values at the circuit node (P) which are greater than a first predetermined value (U1), the second voltage reference (RV2) is arranged to provide a reference voltage such that the second threshold comparator (K2) generates a control signal for the activation of the biasing voltage generator (VDC) only for potential values at the circuit node (P) which are greater than a second predetermined value (U2) lower than the first predetermined value (U1), and the third voltage reference (RV3) is arranged to provide a reference voltage such that the third threshold comparator (K3) generates a control signal for the closure of the second switch (SW2) only for potential values at the circuit node (P) which are greater than a third predetermined value (U3) which is lower than the second predetermined value (U2) and greater than the potential value at the second supply terminal (-Vcc).

3. An audio amplifier as claimed in claim 2, characterized by comprising first (R1), second (R2), and third (R3) resistors connected between the circuit node (P) and the second supply terminal (-Vcc), the second resistor (R2) and the third resistor (R3) being connected to the second supply terminal (-Vcc) via third (SW3) and fourth (SW4) switches, respectively.

4. An integrated circuit characterized by comprising an audio amplifier as claimed in any one of the preceding claims.

## Patentansprüche

1. Audioverstärker, welcher umfaßt eine Verstärkerschaltung (OP), die mindestens eine Eingangsklemme (IN) besitzt zur Verbindung mit einem Vorspannungsgenerator (V_{DC}) des Typs, bei dem die erzeugte Spannung von dem Ladezustand eines Kondensators abhängt, mindestens eine Ausgangsklemme (OUT) zur Verbindung mit einer Last, eine Ausgangsstufe, die zwischen ersten (+V_{cc}) und zweiten (-V_{cc}) Versorgungsklemmen angeschlossen ist, Vorspannungs-Schaltungsmittel (CM) zur Vorspannungsversorgung mindestens der Ausgangsstufe, angeschlossen zwischen der ersten (+V_{cc}) und der zweiten (-V_{cc}) Versorgungsklemme, und einen gemeinsamen Schaltungsknoten (P), der mit der zweiten Versorgungsklemme (-V_{cc}) über einen Kondensator (C) und mit der ersten Versorgungsklemme (+V_{cc}) über eine Stromgeneratorquelle (I_{REF}) angeschlossen ist, welcher Verstärker **dadurch gekennzeichnet** ist, daß er umfaßt einen ersten Schalter (SW₁) zum Verbinden der Eingangsklemme mit einer Signalklemme (V_{SIGN}) und erste (K₁), zweite (K₂) und dritte (K₃) Schwellwert-Komparatoren, die jeweils erste und zweite Eingangsklemmen und eine Ausgangsklemme besitzen, von denen die erste Eingangsklemme jedes Schwellwert-Komparators an dem gemeinsamen Schaltungsknoten (P) angeschlossen ist, die zweite Eingangsklemme des ersten Schwellwert-Komparators (K₁), die zweite Eingangsklemme des Zweiten Schwellwert-Komparators (K₂) und die zweite Eingängsklemme des dritten Schwellwert-Komparators (K₃) jeweils mit einer ersten (RV₁), bzw. einer zweiten (RV₂) und einer dritten (RV₃) Spannungsreferenz verbunden ist, die Ausgangsklemme des ersten Schwellwert-Komparators (K₁), die Aus- gangsklemme des zweiten Schwellwert-Komparators (K₂) und die Ausgangsklemme des dritten Schwellwert-Komparators (K₃) jeweils mit dem ersten Schalter (SW₁), dem Vorspannungsgenerator (V_{DC}) bzw. einem zweiten Schalter (SW₂) verbunden ist, der zweite Schalter in Reihe mit dem Vorspannungsschaltungsmittel (CM) zwischen der ersten (+V_{cc}) und der zweiten (-V_{cc}) Versorgungsklemme liegt; der erste (SW₁) und der zweite (SW₂) Schalter und der Vorspannungsgenerator (V_{DC}) durch den ersten (K₁), den dritten (K₃) bzw. den zweiten (K₂) Schwellwert-Komparator gesteuert werden.

2. Audioverstärker nach Anspruch 1, **dadurch gekennzeichnet**, daß die erste Spannungsreferenz (RV₁) ausgelegt ist, eine Referenzspannung so zu schaffen, daß der erste Schwellwert-Komparator (K₁) ein Steuersignal für das Schließen des ersten Schalters (SW₁) nur bei Potentialwerten an dem Schaltungsknoten (P) ergibt, die größer als ein erster vorbestimmter Wert (U₁) sind, die zweite Spannungsreferenz (RV₂) ausgelegt ist, eine Referenzspannung so zu schaffen, daß der zweite Schwellwert-Komparator (K₂) ein Steuersignal für die Aktivierung des Vorspannungsgenerators (V_{DC}) nur bei Potentialwerten an dem Schaltungsknoten (P) ergibt, die größer als ein zweiter vorbestimmter Wert (U₂) sind, der niedriger als der erste vorbestimmte Wert (U₁) ist, und die dritte Spannungsreferenz (RV₃) ausgelegt ist, eine Referenzspannung so zu schaffen, daß der dritte Schwellwert-Komparator (K₃) ein Steuersignal für das Schließen des zweiten Schalters (SW₂) nur bei Potentialwerten an dem Schaltungsknoten (P) ergibt, die größer als ein dritter vorbestimmter Wert (U₃) sind, der kleiner als der zweite vorbestimmte Wert (U₂) und größer als der Potentialwert an der zweiten Versorgungsklemme (-V_{cc}) ist.

3. Audioverstärker nach Anspruch 2, **dadurch gekennzeichnet**, daß er umfaßt einen ersten (R₁), einen zweiten (R₂) und einen dritten (R₃) Widerstand, welche Widerstände jeweils zwischen dem Schaltungsknoten (P) und der zweiten Versorgungsklemme (-V_{cc}) angeschlossen sind, wobei der zweite Widerstand (R₂) und der dritte Widerstand (R₃) an der zweiten Versorgungsklemme (-V_{cc}) jeweils über einen dritten (SW₃) bzw. einen vierten (SW₄) Schalter angeschlossen sind.

4. Integrierte Schaltung, dadurch gekennzeichnet, daß sie einen Audioverstärker nach einem der vorangehenden Ansprüche umfaßt.

## Revendications

1. Amplificateur audio comprenant un circuit d'amplificateur (OP) qui comporte au moins une borne d'entrée (IN) en vue d'une connexion à un générateur de tension de polarisation (VDC) du type dans lequel la tension générée dépend de la condition de charge d'une capacité, au moins une borne de sortie (OUT) en vue d'une connexion à une charge, un étage de sortie connecté entre des première (+Vcc) et seconde (-Vcc) bornes d'alimentation, un moyen de circuit de polarisation (CM) pour polariser au moins l'étage de sortie connecté entre les première (+Vcc) et seconde (-Vcc) bornes d'alimentation et un noeud de circuit commun (P) qui est connecté à la seconde borne d'alimentation (-Vcc) via une capacité (C) et à la première borne d'alimentation (+Vcc) via une source de générateur de courant (IREF), l'amplificateur étant caractérisé en ce qu'il comprend un premier commutateur (SW1) pour connecter ladite borne d'entrée et une source de signal (VSIGN) et en ce qu'il comprend des premier (K1), second (K2) et troisième (K3) comparateurs de seuil dont chacun comporte des première et seconde bornes d'entrée et une borne de sortie, la première borne d'entrée de chacun des comparateurs de seuil étant connectée audit noeud de circuit commun (P), la seconde borne d'entrée du premier comparateur de seuil (K1), la seconde borne d'entrée du second comparateur de seuil (K2) et la seconde borne d'entrée du troisième comparateur de seuil (K3) étant connectées respectivement à des première (RV1), seconde (RV2) et troisième (RV3) références de tension, la borne de sortie du premier comparateur de seuil (K1), la borne de sortie du second comparateur de seuil (K2) et la borne de sortie du troisième comparateur de seuil (K3) étant respectivement connectées au premier commutateur (SW1), au générateur de tension de polarisation (VDC) et à un second commutateur (SW2), le second commutateur étant connecté en série avec le moyen de circuit de polarisation (CM) entre les première (+Vcc) et seconde (-Vcc) bornes d'alimentation, les premier (SW1) et second (SW2) commutateurs et le générateur de tension de polarisation (VDC) étant respectivement commandés par les premier (K1), troisième (K3) et second (K2) comparateurs de seuil.

2. Amplificateur audio selon la revendication 1, caractérisé en ce que la première référence de tension (RV1) est agencée pour produire une tension de référence qui est telle que le premier comparateur de seuil (K1) génère un signal de commande pour la fermeture du premier commutateur (SW1) seulement pour des valeurs de potentiel au niveau du noeud de circuit (P) qui sont supérieures à une première valeur prédéterminée (U1), la seconde référence de tension (RV2) est agencée pour produire une tension de référence qui est telle que le second comparateur de seuil (K2) génère un signal de commande pour l'activation du générateur de tension de polarisation (VDC) seulement pour des valeurs de potentiel au niveau du noeud de circuit (P) qui sont supérieures à une seconde valeur prédéterminée (U2) inférieure à la première valeur prédéterminée (U1) et la troisième référence de tension (RV3) est agencée pour produire une tension de référence de telle sorte que le troisième comparateur de seuil (K3) génère un signal de commande pour la fermeture du second commutateur (SW2) seulement pour des valeurs de potentiel au niveau du noeud de circuit (P) qui sont supérieures à une troisième valeur prédéterminée (U3) qui est inférieure à la seconde valeur prédéterminée (U2) et supérieure à la valeur de potentiel au niveau de la seconde borne d'alimentation (-Vcc).

3. Amplificateur audio selon la revendication 2, caractérisé en ce qu'il comprend des première (R1), seconde (R2) et troisième (R3) résistances connectées entre le noeud de circuit (P) et la seconde borne d'alimentation (-Vcc), la seconde résistance (R2) et la troisième résistance (R3) étant connectées à la seconde borne d'alimentation (-Vcc) via respectivement les troisième (SW3) et quatrième (SW4) commutateurs.

4. Circuit intégré caractérisé en ce qu'il comprend un amplificateur audio selon l'une quelconque des revendications précédentes.
